(19) Europäisches Patentamt
European Patent Office
Office européen des brevets

(11) **EP 1 584 112 B1**

(12) **FASCICULE DE BREVET EUROPEEN**

(45) Date de publication et mention
de la délivrance du brevet:
**25.07.2007 Bulletin 2007/30**

(21) Numéro de dépôt: **03814491.1**

(22) Date de dépôt: **24.12.2003**

(51) Int Cl.:
***H01L 37/00*** *(2006.01)*

(86) Numéro de dépôt international:
**PCT/FR2003/003894**

(87) Numéro de publication internationale:
**WO 2004/061984 (22.07.2004 Gazette 2004/30)**

(54) **GÉNÉRATEUR ASYNCHRONE À EFFET GALVANOMAGNÉTOTHERMIQUE**

ASYNCHRONER GENERATOR MIT GALVANOMAGNETOTHERMISCHEM EFFEKT

ASYNCHRONOUS GENERATOR WITH GALVANOMAGNETOTHERMAL EFFECT

(84) Etats contractants désignés:
**AT BE BG CH CY CZ DE DK EE ES FI FR GB GR HU IE IT LI LU MC NL PT RO SE SI SK TR**

(30) Priorité: **27.12.2002 FR 0216754**

(43) Date de publication de la demande:
**12.10.2005 Bulletin 2005/41**

(73) Titulaire: **Fouti-Makaya Innovations
31772 Colomiers (FR)**

(72) Inventeur: **FOUTI-MAKAYA, Zacharie
F-11600 Fraisse Cabardes (FR)**

(74) Mandataire: **Hartmann, Jean-Luc
Santarelli
Immeuble Innopolis A, BP 388
31314 Labège Cedex (FR)**

(56) Documents cités:
**EP-A- 0 644 599          DE-A- 2 404 786
FR-A- 1 208 159          US-A- 3 084 267**

## Description

La présente invention concerne un générateur asynchrone à effet galvanomagnétothermique.

Il s'agit ici de réaliser un générateur utilisant les propriétés thermoélectriques de certains matériaux. Un tel générateur est relié d'une part à une source chaude et d'autre part à une source froide. Il peut alors fonctionner soit comme une pompe à chaleur, soit comme un générateur électrique. Dans le premier cas, le générateur puise de l'énergie à la source froide pour l'apporter à la source chaude. Dans le second cas, un transfert d'énergie s'effectue de la source chaude vers la source froide avec production d'énergie électrique.

Le document EP-0 644 599 décrit un dispositif générateur thermoélectrique produisant de l'énergie électrique à partir d'énergie thermique en utilisant l'effet Nernst. Le dispositif décrit comprend un élément de conversion réalisé dans un matériau présentant des propriétés thermoélectriques, des moyens pour générer un champ magnétique, des moyens de chauffage et de refroidissement de manière à créer un gradient de température perpendiculaire au champ magnétique. L'élément présentant des propriétés thermoélectriques est fendu et chaque bord de la fente comporte une électrode. Une différence de potentiel apparaît entre ces deux électrodes en présence du champ magnétique et du gradient de température. L'inconvénient d'un tel dispositif est que la différence de potentiel entre deux électrodes est au mieux de l'ordre du Volt. Il faut donc coupler plusieurs éléments pour obtenir des tensions plus importantes. La puissance fournie par un tel dispositif est en outre relativement faible. De ce fait le rendement énergétique est lui aussi très faible.

La présente invention a alors pour but de fournir un générateur électrique utilisant l'effet Nernst pour obtenir un rendement intéressant permettant une exploitation économiquement intéressante.

A cet effet, elle propose un générateur asynchrone à effet galvanomagnétothermique comportant :

- des moyens pour générer un champ magnétique selon une première direction,
- une source chaude et une source froide créant un gradient de température dans une seconde direction sensiblement perpendiculaire à la première direction, et
- au moins un élément présentant des propriétés de conversion themoélectrique, disposé dans un plan sensiblement perpendiculaire à la direction du gradient de température.

Selon l'invention, le champ magnétique généré est un champ d'ondes progressives se déplaçant selon la seconde direction, et chaque élément présentant des propriétés de conversion thermoélectrique présente une forme continue dans le plan perpendiculaire à la seconde direction.

De cette manière, on génère au niveau des éléments présentant des propriétés de conversion thermoélectrique un champ électrique en court-circuit. Il devient alors possible de récupérer au niveau des moyens pour générer un champ magnétique un courant électrique. Au bilan de ce dispositif générateur, un signal consommant essentiellement de la puissance réactive est envoyé pour créer un champ magnétique et grâce à la conversion thermoélectrique, il est possible de récupérer un courant électrique et de la puissance active.

Une première forme de réalisation prévoit qu'un générateur selon l'invention comporte plusieurs éléments présentant des propriétés de conversion thermoélectrique, chacun de ces éléments présentant une forme annulaire et étant disposé dans un plan perpendiculaire à la seconde direction. Dans une autre forme de réalisation, l'élément présentant des propriétés de conversion thermoélectrique est par exemple de forme tubulaire cylindrique et s'étend selon la seconde direction.

Pour un meilleur rendement du dispositif, on choisit pour chaque élément présentant des propriétés de conversion thermoélectrique un matériau présentant un coefficient de Nernst intéressant. Il est alors proposé de réaliser ces éléments à base d'antimoniure d'indium (InSb).

Les moyens pour générer un champ magnétique comportent par exemple d'une part un noyau ferromagnétique et d'autre part des inducteurs sous forme de bobines alimentées électriquement.

Dans une autre variante de réalisation, les moyens pour générer un champ magnétique comportent des inducteurs sous forme de bobines alimentées électriquement, ces inducteurs étant disposés deux à deux l'un face à l'autre de telle sorte que dans l'entrefer de deux inducteurs correspondants se trouve au moins un élément présentant des propriétés de conversion thermoélectrique.

On peut envisager une auto-excitation du dispositif générateur. Dans ce cas, une partie du courant généré est utilisée pour l'alimentation des inducteurs.

Pour augmenter le rendement d'un générateur selon l'invention, les inducteurs sont réalisés avantageusement par des bobinages supraconducteurs.

Des détails et avantages de l'invention ressortiront mieux de la description qui suit, faite en référence au dessin schématique annexé sur lequel :

La figure 1 est un schéma de principe d'une première forme de réalisation d'un générateur selon l'invention,
La figure 2 montre schématiquement une variante de réalisation du générateur de la figure 1,
La figure 3 montre une variante de réalisation du générateur de la figure 2, et
La figure 4 montre un schéma électrique de principe d'un circuit permettant de réaliser l'auto-excitation d'un générateur des figures 1 à 3.

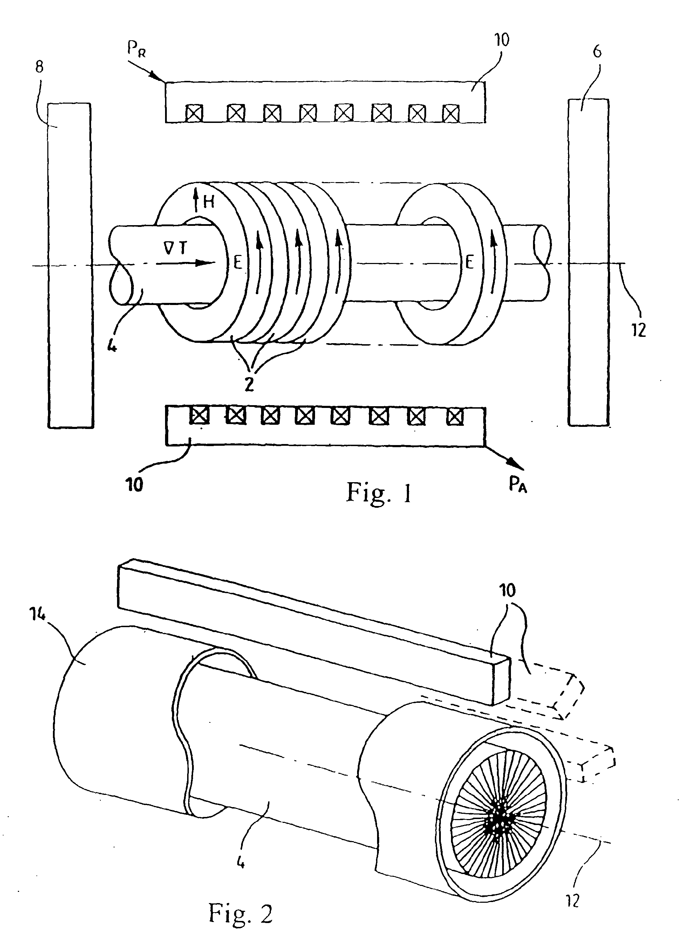

Sur la figure 1 sont schématisés des éléments annulaires 2 présentant des propriétés de conversion thermoélectriques, un noyau magnétique 4, une source chaude 6, une source froide 8 et des inducteurs 10.

Les éléments annulaires 2 sont ainsi soumis d'une part à un gradient de température $\nabla T$ et d'autre part à un champ magnétique H. Compte tenu des propriétés thermoélectriques des éléments annulaires 2, il se crée un champ électrique E dans chacun de ces anneaux. La création de ce champ électrique est également connue sous le nom d'effet Nernst.

Dans la forme de réalisation représentée sur la figure 1, on remarque que le dispositif présente une symétrie de rotation par rapport à un axe longitudinal 12. Le gradient de température VT est parallèle à cet axe de rotation tandis que le champ magnétique H est radial par rapport à cet axe. Le champ électrique est donné par l'équation suivante :

$$\vec{E} = N\vec{H} \wedge \vec{\nabla} T$$

où N est le coefficient de Nernst et où l'opérateur ^ représente un produit vectoriel. Dans ces conditions, le champ électrique E est en tout point perpendiculaire à la fois au champ magnétique H et au gradient de température. On a ainsi une circulation tangentielle du champ électrique E.

La source chaude 6 peut être par exemple une source chaude produite par une centrale thermique ou équivalent. La source froide 8 est obtenue par un système de refroidissement. Une isolation thermique, non représentée au dessin, permet d'isoler la source chaude 6 de la source froide 8.

Les inducteurs 10 sont alimentés en courant alternatif de manière à créer avec l'aide du noyau 4 un champ magnétique H au niveau des éléments annulaires 2. L'alimentation est faite de telle sorte qu'une onde magnétique progressive se déplace longitudinalement par rapport à l'axe 12. On crée ainsi un champ magnétique glissant se déplaçant selon la direction de cet axe 12. On retrouve ici une structure proche de celle d'une pompe électromagnétique annulaire au sodium. Ici, la veine de liquide sodium est remplacée par la succession d'éléments annulaires 2. On choisit ici pour réaliser ces anneaux, un matériau présentant un coefficient de Nernst important. L'antimoniure d'indium (InSb) convient pour une telle application.

Les inducteurs 10 peuvent être monophasés ou polyphasés, de préférence triphasés. Comme indiqué plus haut, ils engendrent une onde progressive d'induction sinusoïdale au niveau des éléments annulaires 2. Cette onde d'induction est appelée onde inductrice ou primaire. Cette onde en mouvement relatif par rapport au matériau thermoélectrique induit dans chaque élément annulaire 2 un système de courants polyphasés se refermant sur eux-mêmes. Ces courants créent à leur tour une distribution sinusoïdale progressive d'induction appelée onde secondaire ou réaction d'induit. Cette seconde onde est stationnaire par rapport à la première. Tout se passe ici comme dans un convertisseur électromécanique mettant en oeuvre deux champs progressifs ou tournants de même vitesse.

Le système décrit peut fonctionner en générateur ou en récepteur. Lorsque le paramètre de transport du matériau constituant les éléments annulaires 2 est supérieur à la vitesse du champ primaire, le système fonctionne en générateur. Il fonctionne en récepteur dans le cas contraire. L'énergie électrique échangée entre le réseau et le dispositif représenté au dessin apparaît dans les inducteurs 10, si bien qu'il n'existe aucun contact électrique entre l'induit et toute autre partie du dispositif.

Le paramètre de transport dont il est question ici a les dimensions d'une vitesse. Il correspond à N.$\nabla T$ où N est le coefficient de Nernst et où $\nabla T$ est le gradient de température. Pour l'antimoniure d'indium, au voisinage d'une température de 300 K on a N = (-5.7e$^{(T-273)/65}$- 3.2) * 10$^{-5}$ m$^2$ K$^{-1}$ s$^{-1}$ (d'après l'article de H. Nakamura, K. Ikeda, S. Yamaguchi, et K. Kuroda, Transport coefficients of thermoelectric semiconductor InSb in the magnetic field, J. Adv. Sci., 8 (1996), 153(in Japanese*)*).

On retrouve ici aussi une analogie avec les pompes électromagnétiques annulaires au sodium. En effet, lorsqu'une telle pompe fonctionne en pompe, on envoie dans les bobinages de celle-ci un courant créant un champ magnétique progressif et le sodium se déplace à une vitesse inférieure à la vitesse de progression de l'onde magnétique. Si par contre le fluide circule plus rapidement que l'onde magnétique primaire, la pompe fonctionne en génératrice (cf article de F. JOUSSELLIN et al.. M.H.D. induction generator at weak magnetic Reynolds number. EUROPEAN JOURNAL OF MECHANICS, B/FLUIDS, VOL. 8, N° 4, 1989 © Gauthier-Villars).

Le générateur, qui peut également fonctionner en récepteur, asynchrone galvanothermomagnétique selon l'invention fonctionne suivant le même principe qu'un transformateur linéaire dont l'enroulement secondaire est un court-circuit. Dans les formes de réalisation représentées, ce générateur a une structure linéaire car les inducteurs produisent une induction glissante. L'induit quant à lui est fixe.

Encore par analogie aux machines électriques existantes, alors que le rotor d'un moteur asynchrone est constitué de conducteurs (rotor bobiné ou à cage), l'induit linéaire du présent dispositif est constitué d'éléments annulaires (figure 1) ou d'un tube (figure 2), les courants induits circulant dans la masse même de ces éléments ou de ce tube. En outre, alors qu'un moteur rotatif n'a qu'un seul stator inducteur, le générateur selon l'invention utilise de préférence deux inducteurs qui se font face. On peut également, comme sur les figures 1 et 2, avoir un inducteur faisant face à un noyau magnétique 4. Une telle disposition présente l'avantage de faciliter d'une part le flux dans le circuit magnétique et d'augmenter d'autre part l'induction dans l'entrefer. On réalise ainsi une épaisseur d'entrefer plus grande. Enfin, alors qu'un moteur rotatif a un inducteur fixe et un induit mobile, le générateur linéaire selon l'invention peut avoir l'une ou l'autre des deux dispositions statiques suivantes :

- l'induit est plus court que l'inducteur supposé alors infiniment long : le générateur est alors dit "à inducteur long",
- l'inducteur est plus court que l'induit qui est alors supposé infiniment long : le générateur est alors dit "à inducteur court".

Dans la forme de réalisation de la figure 2, les éléments annulaires 2 sont remplacés par un tube 14. Sur cette figure, on retrouve également un noyau magnétique 4 placé au centre du tube 14, l'ensemble formé par le noyau et le tube étant entouré d'inducteurs 10 régulièrement répartis à la périphérie du tube. On retrouve ici un dispositif présentant un axe de révolution 12.

Le tube est réalisé ici aussi de préférence en antimoniure d'indium. D'autres matériaux tels les tellurures et les séléniures de plomb, de bismuth et d'antimoine ou bien encore certains alliages de silicium et de germanium peuvent être utilisés. Bien entendu, cette liste n'est pas exhaustive.

De même que pour le dispositif de la figure 1, on alimente ici les inducteurs, de préférence en triphasé, de manière à créer une onde magnétique progressive dans le tube 14. Le champ électrique créé alors dans le tube 14, lorsque le dispositif travaille en générateur, induit à son tour un courant dans les inducteurs 10. Ces derniers absorbent donc d'une part de la puissance réactive $P_R$ et fournissent d'autre part de la puissance active $P_A$ fournie grâce au champ électrique créé dans le matériau thermoélectrique.

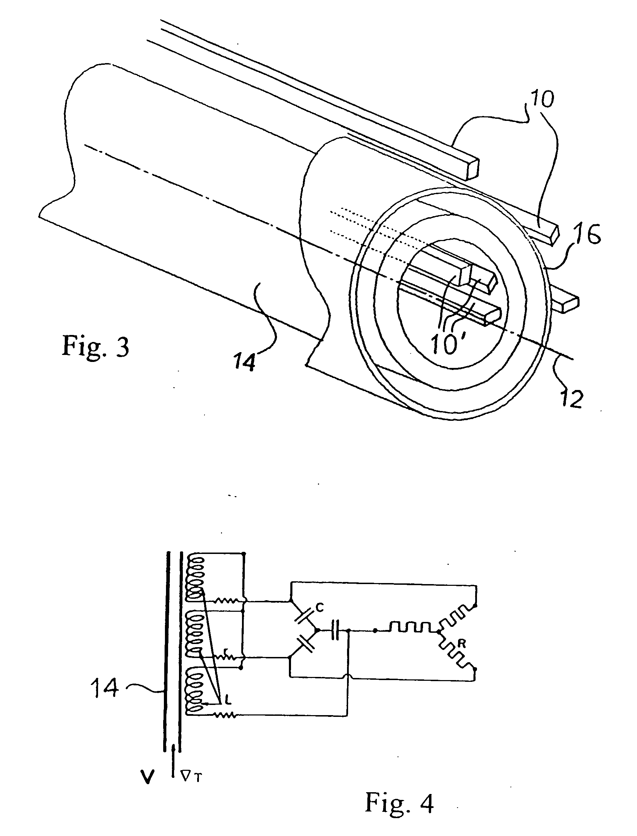

La figure 3 montre une variante de réalisation comparable à la forme de réalisation représentée sur la figure 2. Ici le noyau magnétique est remplacé par des inducteurs 10'. Le fonctionnement de ce dispositif est alors similaire à celui décrit plus haut en référence à la figure 2. Sur cette figure, on a également représenté une enveloppe isolante 16. Cette dernière a pour but d'isoler thermiquement le tube 14 thermoélectrique afin de ne pas dégrader le gradient de température. Bien entendu, le matériau choisi pour la réalisation de l'enveloppe isolante 16 est un matériau perméable magnétiquement.

Il est envisageable d'auto-exciter le générateur. Une telle auto-excitation peut être réalisée comme décrit dans l'article de F. JOUSSELLIN et al. cité plus haut. Des condensateurs sont alors utilisés pour l'alimentation des inducteurs. Ces condensateurs sont de préférence alimentés par une partie du courant généré. La figure 4 montre un schéma électrique (extrait de l'article précité) d'un dispositif permettant de réaliser une telle auto-excitation. On considère ici que le générateur fonctionne en mode triphasé. On représente alors trois bobines d'inductance L, à chacune de ces bobines correspondant une phase de courant triphasé. Les bobines représentées ici sont des bobines d'un inducteur 10 (ou 10') des figures 1 à 3. Chaque bobine n'étant pas une inductance pure, on a représenté également une résistance r correspondant à chaque bobine. On a également représenté sur la figure 4 le tube 14 des figures 2 et 3. V est la vitesse de l'onde progressive générée par les bobines dans le matériau thermoélectrique constituant le tube 14. Elle est sensiblement parallèle au gradient de température ∇T. Les valeurs C et R correspondent à des capacités et à des résistances. Elles définissent, avec la valeur L de l'inductance des bobines, la pulsation des oscillations créant un champ magnétique dans le tube 14.

Pour augmenter le rendement du dispositif, il est envisageable d'utiliser des bobinages supraconducteurs pour réaliser les inducteurs 10.

Comme évoqué plus haut, il est possible de remplacer le noyau magnétique par un ensemble d'inducteurs (figure 3). On a alors des inducteurs se faisant face. Pour avoir plus de place pour les inducteurs se trouvant à l'intérieur du dispositif, il est envisageable aussi d'avoir une structure plane. Dans ce cas, on peut prévoir par exemple une plaque de matériau thermoélectrique, de préférence circulaire plane. Sur les deux faces de celle-ci, des inducteurs s'étendent alors radialement. On a alors un disque thermoélectrique pris en sandwich entre deux réseaux d'inducteurs disposés en étoile. Le gradient de température est lui aussi alors radial. On peut par exemple supposer de chauffer le centre du disque thermoélectrique et de refroidir sa périphérie. Bien entendu, le disque en matériau thermoélectrique peut être évidé en son centre.

La présente invention ne se limite pas aux formes de réalisation et à leurs variantes décrites ci-dessus à titre d'exemples non limitatifs. Elle concerne également toutes variantes de réalisation à la portée de l'homme du métier dans le cadre des revendications ci-après.

## Revendications

**1.** Générateur asynchrone à effet galvanomagnétothermique comportant :

- des moyens (4, 10) pour générer un champ magnétique selon une première direction,
- une source chaude (6) et une source froide (8) créant un gradient de température (∇T) dans une seconde direction sensiblement perpendiculaire à la première direction, et
- au moins un élément (2 ; 14) présentant des propriétés de conversion thermoélectrique, disposé dans un plan sensiblement perpendiculaire à la direction du gradient de température (∇T),

**caractérisé en ce que** le champ magnétique généré est un champ d'ondes progressives se déplaçant selon la seconde direction, et **en ce que** chaque élément présentant des propriétés de conversion thermoélectrique présente une forme continue dans le plan perpendiculaire à la seconde direction.

2. Générateur asynchrone selon la revendication 1, **caractérisé en ce qu'**il comporte plusieurs éléments (2) présentant des propriétés de conversion thermoélectrique, chacun de ces éléments présentant une forme annulaire et étant disposé dans un plan perpendiculaire à la seconde direction.

3. Générateur asynchrone selon la revendication 1, **caractérisé en ce qu'**il comporte un élément (14) présentant des propriétés de conversion thermoélectrique de forme tubulaire cylindrique s'étendant selon la seconde direction.

4. Générateur asynchrone selon l'une des revendications 1 à 3, **caractérisé en ce que** chaque élément (2, 14) présentant des propriétés de conversion thermoélectrique est réalisé à base d'antimoniure d'indium (InSb).

5. Générateur asynchrone selon l'une des revendications 1 à 4, **caractérisé en ce que** les moyens pour générer un champ magnétique comportent d'une part un noyau ferromagnétique (4) et d'autre part des inducteurs (10) sous forme de bobines alimentées électriquement.

6. Générateur asynchrone selon l'une des revendications 1 à 4, **caractérisé en ce que** les moyens pour générer un champ magnétique comportent des inducteurs sous forme de bobines alimentées électriquement, ces inducteurs étant disposés deux à deux l'un face à l'autre de telle sorte que dans l'entrefer de deux inducteurs correspondants se trouve au moins un élément présentant des propriétés de conversion thermoélectrique.

7. Générateur asynchrone selon l'une des revendications 5 ou 6, **caractérisé en ce qu'**une partie du courant généré est utilisée pour l'alimentation des inducteurs.

8. Générateur asynchrone selon l'une des revendications 5 à 7, **caractérisé en ce que** les inducteurs sont réalisés par des bobinages supraconducteurs.

**Claims**

1. A galvano-magneto-thermal effect asynchronous generator comprising:

    - means (4, 10) for generating a magnetic field in a first direction,
    - a hot source (6) and a cold source (8) creating

a temperature gradient ($\nabla T$)in a second direction substantially perpendicular to the first direction, and
    - at least one element (2 ; 14) having thermoelectric conversion properties, disposed in a plane substantially perpendicular to the direction of the temperature gradient ($\nabla T$),

    **characterized in that** the magnetic field generated is a field of traveling waves moving in the second direction, and **in that** each element having thermoelectric conversion properties has a continuous form in the plane perpendicular to the second direction.

2. An asynchronous generator according to claim 1, **characterized in that** it comprises several elements (2) having thermoelectric conversion properties, each of those elements having an annular form and being disposed in a plane perpendicular to the second direction.

3. An asynchronous generator according to claim 1, **characterized in that** it comprises an element (14) having thermoelectric conversion properties of tubular cylindrical form extending in the second direction.

4. An asynchronous generator according to one of claims 1 to 3, **characterized in that** each element (2, 14) having thermoelectric conversion properties is produced using indium antimonide (InSb).

5. An asynchronous generator according to one of claims 1 to 4, **characterized in that** the magnetic field generating means comprise both a ferromagnetic core (4) as well as inductors (10) in the form of electrically powered coils.

6. An asynchronous generator according to one of claims 1 to 4, **characterized in that** the magnetic field generating means comprise inductors in the form of electrically powered coils, those inductors being arranged two by two with one facing the other such that in the gap between two corresponding inductors there is at least one element having thermoelectric conversion properties.

7. An asynchronous generator according to one of claims 5 or 6, **characterized in that** a part of the current generated is used to power the inductors.

8. An asynchronous generator according to one of claims 5 to 7, **characterized in that** the inductors are formed by superconducting windings.

**Patentansprüche**

1. Asynchroner Generator mit galvanomagnetothermischem Effekt, umfassend:

- Mittel (4, 10) zum Erzeugen eines Magnetfeld gemäß einer ersten Richtung,
- eine Heizquelle (6) und eine Kältequelle (8), die einen Temperaturgradienten ($\Delta T$) in einer zweiten Richtung im Wesentlichen senkrecht zur ersten Richtung erzeugen, und
- mindestens ein Element (2; 14), das thermoelektrische Umwandlungseigenschaften aufweist, angeordnet in einer Ebene im Wesentlichen senkrecht zur Richtung des Temperaturgradienten ($\Delta T$),

**dadurch gekennzeichnet, dass** das erzeugte Manetfeld ein progressives Wellenfeld darstellt, das sich in der zweiten Richtung verschiebt, und dass jedes Element, das thermoelektrische Umwandlungseigenschaften aufweist, in der Ebene senkrecht zur zweiten Richtung eine fortlaufende Form darstellt.

2. Asynchroner Generator nach Anspruch 1, **dadurch gekennzeichnet, dass** er mehrere Elemente (2) umfasst, die thermoelektrische Umwandlungseigenschaften aufweisen, wobei jedes dieser Elemente eine ringförmige Form aufweist und in einer Ebene senkrecht zur zweiten Richtung angeordnet ist.

3. Asynchroner Generator nach Anspruch 1, **dadurch gekennzeichnet, dass** er ein thermoelektrische Umwandlungseigenschaften aufweisendes Element (14) in Form eines zylindrischen Rohrs umfasst, das sich in der zweiten Richtung erstreckt.

4. Asynchroner Generator nach einem der Ansprüche 1 bis 3, **dadurch gekennzeichnet, dass** jedes thermoelektrische Umwandlungseigenschaften aufweisende Element (2, 14) auf Basis einer Indiumantimonverbindung (InSb) hergestellt ist.

5. Asynchroner Generator nach einem der Ansprüche 1 bis 4, **dadurch gekennzeichnet, dass** die Mittel zum Erzeugen eines Magnetfelds einerseits einen ferromagnetischen Kern (4) und andererseits Induktoren (10) in Form von elektrisch gespeisten Spulen umfassen.

6. Asynchroner Generator nach einem der Ansprüche 1 bis 4, **dadurch gekennzeichnet, dass** die Mittel zum Erzeugen eines Magnetfelds Induktoren in Form von elektrisch gespeisten Spulen aufweisen, wobei diese Induktoren paarweise einer gegenüber dem anderen in der Art und Weise angeordnet sind, dass sich im Luftspalt von zwei entsprechenden Induktoren mindestens ein Element befindet, das thermoelektrische Umwandlungseigenschaften aufweist.

7. Asynchroner Generator nach einem der Ansprüche 5 oder 6, **dadurch gekennzeichnet, dass** ein Teil des erzeugten Stroms zur Versorgung der Induktoren verwendet wird.

8. Asynchroner Generator nach einem der Ansprüche 5 bis 7, **dadurch gekennzeichnet, dass** die Induktoren durch supraleitende Spulen verwirklicht sind.

Fig. 1

Fig. 2

Fig. 3

Fig. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0644599 A

**Littérature non-brevet citée dans la description**

- **H. NAKAMURA ; K. IKEDA ; S. YAMAGUCHI ; K. KURODA.** Transport coefficients of thermoelectric semiconductor InSb in the magnetic field. *J. Adv. Sci,* 1996, vol. 8, 153

- M.H.D. induction generator at weak magnetic Reynolds number. **F. JOUSSELLIN et al.** EUROPEAN JOURNAL OF MECHANICS, B/FLUIDS. Gauthier-Villars, 1989, vol. 8